(19) Europäisches Patentamt

European Patent Office

Office européen des brevets

(11) **EP 0 881 766 A1**

(12) **EUROPEAN PATENT APPLICATION**

(43) Date of publication:
**02.12.1998 Bulletin 1998/49**

(51) Int. Cl.$^6$: **H03K 3/84**

(21) Application number: **97303475.4**

(22) Date of filing: **21.05.1997**

(84) Designated Contracting States:
**AT BE CH DE DK ES FI FR GB GR IE IT LI LU MC NL PT SE**
Designated Extension States:
**AL LT LV RO SI**

(71) Applicant:
**AMERSHAM INTERNATIONAL plc**
**Little Chalfont Buckinghamshire HP7 9NA (GB)**

(72) Inventor:
**The designation of the inventor has not yet been filed**

(74) Representative: **Perkins, Sarah**
**Stevens, Hewlett & Perkins**
**1 Serjeants' Inn**
**Fleet Street**
**London EC4Y 1LL (GB)**

(54) **Programmable probability random event generator**

(57)     The programmable probability random event generator includes a radioactive random pulse generator (RPG) the output of which is connected to an analyser. The analyser includes a counter for counting the number of pulses produced by the RPG during a predetermined time period. The analyser then determines whether the count meets selected mathematical parameters. Where the parameters are met the analyser then generates an output. The mathematical parameters have been determined to ensure that the analyser generates an output randomly according to a selected probability. The mathematical parameters employed enable the random event generator to operate to generate output at selected probabilities without knowledge of the exact Mean output of the RPG.

EP 0 881 766 A1

**Description**

The present invention relates to a programmable probability random event generator. In particular, the programmable probability random event generator includes a random pulse generator (RPG), for example a radioactive RPG, the output of which is monitored to-generate a random event at a predetermined probability. The programmable probability random event generator is particularly suited for use in gaming machines and in the generation of random numbers.

The uses of radioactive RPGs is well documented both in gaming machines such as a Pachinko machine and also in the generation of random numbers. The generation of individual pulses from a radioactive RPG is completely random and unpredictable but the probability of one or more pulses being generated within a selected time period can be calculated using Poisson or Gaussian probability theory with knowledge of the Mean RPG output. The Mean RPG output is measured by counting the output of the RPG at the factory. This a costly operation because it is necessary for the output of the RPG to be monitored for a long time, usually hours, and because this must be done for every RPG as each individual RPG will have its own Mean output. For gaming machines the Mean output is used to calculate a particular output of the RPG which has the desired probability of occurring, for example a probability of 1/220. The gaming machine is then set up only to generate a win when the calculated output is detected. In the case of the generation of random binary numbers the desired probability is ½ for each digit and an output of the RPG which affords this probability is appropriately calculated.

In all cases where a radioactive RPG has been used to generate random events with a predetermined probability, for the RPG to be used in any meaningful manner the Mean output of the RPG must be known. Furthermore the accuracy of achieving the desired probability is limited to the accuracy with which the Mean output is measured. This accuracy is directly related to the length of time over which the output of the RPG is initially monitored. In practice this means that generally the output of each individual RPG must be monitored for a number of hours to ensure a satisfactory level of accuracy. Moreover, the Mean of a RPG is known to drift over the lifetime of the RPG. The effect of this is that repeated measurements of the Mean must be taken over the lifetime of the RPG to maintain its accuracy or the drift in the Mean must otherwise be accommodated in some way.

The analogy of throwing a die and the associated probability of throwing any particular number will be used to assist in an understanding of the probabilities associated with the number of pulses output from a radioactive pulse generator (RPG). With a die the probability of throwing a specific number is 1/6. The probability of throwing the same number four times is $(1/6)^4$. The probability of throwing an unspecified number 4 times in succession is the sum of the probabilities for all possible numbers:

$$(P_{total}) = \sum_{n=0}^{n=6} (P_n)^4 = (1/6)^4 \times 6 = 1/216$$

In the case of a radioactive RPG, the probability of the RPG emitting an output of (m) pulses is dependent on the Mean output and is defined by the Poisson distribution function:

$$^M P_m = M^m . e^{-M}/m!$$

where:  *(m) is the number of pulses emitted
*(M) is the Mean pulse rate of the RPG
*($^M P_m$) is the probability.

The present invention seeks to address the disadvantages described above with regard to former random event generators which employ a radioactive RPG and to provide an improved random event generator which generates random events at a selected probability, within an acceptable tolerance, ideally without knowledge of the Mean output of the radioactive RPG or with only a very approximate idea of the Mean.

The present invention provides a method of generating a random event comprising counting the number of pulses generated by a random pulse generator within a predetermined time period, determining whether the count of the number of pulses meets a selected mathematical parameter and generating an output when the count meets the selected mathematical parameter, the selected mathematical parameter requiring the count to equal an integer in a numerical series of equally spaced integers.

With the present invention, according to the mathematical parameters employed, the probability of an output being generated is controlled without knowledge of the Mean output of the random pulse generator.

Preferably, the numerical series is infinite and it is determined whether the count meets the mathematical parameter by dividing the count by a selected integer and checking whether the result is also an integer. Alternatively or additionally it is determined whether the count meets the mathematical parameter by summing the count with a selected first integer and then dividing the sum by a selected second integer and checking whether the result is also an integer.

The step of counting the number of pulses generated within a predetermined time period may be repeated one or more times to generate a plurality of counts and each of the plurality of counts may be separately analysed to determine whether the count meets a selected mathematical parameter whereby an output is generated only when all of the plurality of counts meets the selected mathematical parameters. At least two mathematical parameters may be used in the analysis of the plurality of counts divided into a corresponding number of groups of counts, a first group of the plurality of counts being analysed using a first mathematical parameter and at least one further group of the plurality of counts being analysed using at least one further mathematical parameter.

In an alternative aspect, a plurality of counts may be generated successively or simultaneously, with each of the plurality of counts being separately analysed to determine whether each of the counts meets at least one selected mathematical parameter whereby a corresponding output is generated for each of the counts in dependence on which of the mathematical parameters is met, the plurality of outputs forming a numeric string. In this way the method can be employed to generate random numbers.

In a separate aspect the present invention provides a programmable probability random event generator comprising a random pulse generator and an analyser connected to the output of the random pulse generator; the analyser including means for counting the number of pulses generated by the random pulse generator during a predetermined time period, parameter means for determining whether the count of the number of pulses meets a selected mathematical parameter and output means for generating an output when the selected mathematical parameter is met; the selected mathematical parameter requiring the count of the number of pulses to equal an integer in a numerical series of equally spaced integers.

Preferably, the analyser includes memory means for storing one or more mathematical parameters. The analyser may further include selecting means for selecting one or more stored mathematical parameters in dependence on a desired probability.

In a preferred embodiment there is further included factoring means for calculating the integer factors of a desired probability value and said selecting means is connected to the factoring means and selects one or more mathematical parameters in dependence on the calculated integer factors.

As random events can be generated substantially at a predetermined probability without knowledge of the Mean output of the RPG employed in the random event generator, this avoids the need for extensive monitoring of the RPG to determine its Mean and also avoids the effects of a drift in the Mean over the lifetime of the RPG. This additionally means that radioactive material having shorter half-lives may be employed which is generally considered to be better for the environment.

Embodiments of the present invention will now be described, by way of example, with reference to the following examples and the accompanying Figure 1 which is a graph of probability variation with respect to Mean count rate.

It has been found that with any RPG, radioactive or otherwise, the probability that a particular number of pulses (m) will be output from the RPG during a predetermined time period, in which the number (m) falls within an infinite series of regularly spaced integers, converges to a single precise probability value as the Mean RPG output for the predetermined time period increases. Thus, other than at a very low values of the RPG Mean, the probability of the output of the RPG corresponding to any one of an infinite series of numbers is substantially independent of the Mean RPG output.

The following are examples of the infinite numerical series referred to above and the probabilities associated with a RPG emitting a number of pulses (m) which falls within the series:

- numbers (m) divisible by 2 [even series 0, 2, 4, 6...]- probability ½
- numbers (m+1) divisible by 2 [odd series 1, 3, 5...] - probability ½
- numbers (m) divisible by 3 [0, 3, 6, 9...] - probability 1/3
- numbers (m+1) divisible by 3 [2, 5, 8,...] - probability 1/3
- numbers (m+2) divisible by 3 [1, 4, 7...] - probability 1/3
- numbers (m) divisible by 4 [0, 4, 8, 12...] - probability ¼
- numbers (m+1) divisible by 4 [3, 7, 11...] - probability ¼
- numbers (m+2) divisible by 4 [2, 6, 10...] - probability ¼
- numbers (m+3) divisible by 4 [1, 5, 9...] - probability ¼

and so on.

Thus, the probability is ½ that the output of the RPG over a predetermined time period is a number of pulses which is divisible by two and similarly the probability is ½ that the output of the RPG is a number which when added to one, is divisible by two. Similarly, the probability is ¼ that the number of pulses output from a RPG is divisible by four, and so on.

In practice it has been found that above 4 counts per measurement, the probability becomes substantially independent of the RPG Mean. The table below sets out in more detail, to eleven decimal places, how the probabilities for different infinite numerical series converge on a single probability for each series as the Mean output of a RPG increases.

Table 1

| Mean | probability of n+1 divisible by 2 i.e. odd | probability of n divisible by 2 i.e. even | probability of n+1 divisible by 3 i.e. 2,5,8,11.... | probability of n divisible by 3 | probability of n+1 divisible by 4 i.e. 3,7,11,15.. | probability of n divisible by 4 |
|---|---|---|---|---|---|---|
| 0 | 0.00000000000000 | 1.00000000000000 | 0.00000000000000 | 1.00000000000000 | 0.00000000000000 | 1.00000000000000 |
| 0.5 | 0.31606027941 | 0.68393972059 | 0.075974434193 | 0.61917988095 | 0.01263699560 | 0.60811022540 |
| 1 | 0.43233235838 | 0.56766764162 | 0.18701451581 | 0.42970463958 | 0.06138624136 | 0.38321687598 |
| 1.5 | 0.47510646582 | 0.52489353418 | 0.26528369978 | 0.35219456293 | 0.12626762485 | 0.27033856866 |
| 2 | 0.49084218056 | 0.50915781944 | 0.30762621607 | 0.32800424042 | 0.18389107787 | 0.22641923473 |
| 3 | 0.49876062391 | 0.50123937609 | 0.33318583289 | 0.32699457359 | 0.24586733621 | 0.22597527599 |
| 4 | 0.49983226869 | 0.50016773131 | 0.33457057091 | 0.33176602958 | 0.25684679495 | 0.24409791540 |
| 5 | 0.49997730004 | 0.50002269996 | 0.33369837955 | 0.33319579227 | 0.25321924049 | 0.25096700037 |
| 6 | 0.49999692789 | 0.50000307211 | 0.33337727484 | 0.33337159976 | 0.25034476483 | 0.25119154815 |
| 7 | 0.49999958424 | 0.50000041576 | 0.33332786285 | 0.33335124446 | 0.25034024500 | 0.25034394282 |
| 8 | 0.49999994373 | 0.50000005627 | 0.33332956402 | 0.33333660651 | 0.24983402551 | 0.24997562322 |
| 9 | 0.49999999239 | 0.50000000761 | 0.33333251593 | 0.33333338791 | 0.24997456646 | 0.24994378260 |
| 10 | 0.49999999897 | 0.50000000103 | 0.33333328467 | 0.33333318615 | 0.25001234874 | 0.24998095362 |
| 11 | 0.49999999986 | 0.50000000014 | 0.33333335996 | 0.33333328806 | 0.25000835070 | 0.25000003703 |

The data shown in the above table is graphically represented in Figure 1 which shows clearly the convergence of the probabilities at around 4 counts. It may also be seen from the graph that when the series of counts starts at zero the probability rises to 1 as the Mean decreases whereas when the series of counts starts at a non-zero value the probability falls to zero as the Mean decreases.

The above theory is employed in the programmable probability random event generator. The random event generator consists of a RPG, preferably employing radioactive material, a clock and an analyser connected to the output of the RPG and the clock. The analyser performs a number of operations including counting the output of the RPG over a predetermined time period; determining whether the count meets a selected mathematical relationship; and generating an output when the count meets the selected mathematical relationship. The selected mathematical relationship which the analyser employs in determining whether to generate an output, may be input directly or may be one of a plurality of mathematical relationships which are stored within the analyser with an associated probability. Thus, the mathematical relationship: 'the number of detected pulses when divided by two produces an integer', would have an associated probability of $\frac{1}{2}$. With this arrangement the desired probability is input into the analyser and the appropriate mathematical relationship selected by the analyser from the stored collection of mathematical relationships.

To generate pure random numbers the probability of measuring one result has to be exactly equal to the probability of measuring any other so that a string of binary digits may be generated. This can be achieved using the programmable probability random event generator with the analyser employing the mathematical relationships which are associated with a probability of $\frac{1}{2}$, i.e. the number of pulses counted is divisible by two and the number of pulses counted plus one is divisible by two. The random event generator is programmed so that a binary output '1' is generated if the number of pulses counted during a predetermined time period meets the first mathematical relationship and a binary output '0' is generated if the count of the number of pulses meets the second of the two mathematical relationships. There is therefore a probability of $\frac{1}{2}$ in each case that the random event generator will generate a binary '1' or a binary '0'.

The output of the random event generator is connected to a multibit RAM with a shift register so that successive outputs from the random event generator may be stored in the RAM as a string of binary digits. Each time period over which the output of the RPG is counted produces a single digit which is stored sequentially within the shift register to generate a random binary number.

Alternatively, only one of the two mathematical relationships may be employed in which case if the number of pulses counted during the predetermined time period meets the mathematical relationship a binary '1' is output and if the number of pulses fails to meet the mathematical relationship a binary '0' is output. It will be apparent that in both cases it is preferred that the shift register and the random event generator are synchronised so that the shift register is not refreshed during a counting cycle of the random event generator.

A hypothetical example of the output of a device for generating random binary numbers is given below:

The random event generator sequentially outputs the following series which has been collected into groups of sixteen outputs RPG count: (7547886359677456)(4866987557984856)(58773... RPG output:(0010111000100101)(1111010000011101)(01000... This series of binary digits has been collected into groups of sixteen to produce analogue numbers between 0 and 65536. The binary groups given above produce the following numbers:

0010111000100101 = 11813
1111010000011101 = 62493

Alternative groupings of digits may be employed as necessary.

Instead of the bits of the binary number being generated sequentially a bank of random event generators may be used each generating its own respective random bit of the binary number. In this way the entire string of binary digits may be generated simultaneously.

An alternative application for the random event generator, is in gaming machines such as a Pachinko machine. Efforts have been made in recent years to employ a radioactive RPG in gaming machines for generating the necessary random 'win'. However, in accordance with gaming regulations the probability of a 'win' arising must be fixed and accurate. This has presented problems to the use of radioactive RPGs in gaming machines because in order to ensure an accurate probability, the Mean output of the RPG must be measured over a period of many hours. In addition, the Mean drifts as the radioactive material decays or the detector performance degrades due to radiation damage from continual alpha bombardment and this in turn can alter the probability of a 'win' event arising.

Recently improvements have been made which address the problems described above and which makes the use of a radioactive RPG in a gaming machine feasible. This improvement is the subject of a separate patent application, no. PCT/GB97/00455, the contents of which is incorporated herein by reference. This improvement relies on the use of a plurality of separate counts either successively using a single RPG or simultaneously using a plurality of RPGs, which are compared according to parameters determined by the desired probability so as to generate a 'win' event, when the plurality of counts meets the parameters set.

The following is an explanation of the theory underlying the gaming random 'win' generator described in PCT/GB97/00455. For a radioactive RPG, the probability of measuring an output (m), (n) times in succession is given by:

$$(^{M}P_{m})^{n} = (M^{m}.e{-}^{M}/m!)^{n}$$

and the combined probability of measuring all unspecified values of (m), (n) times in succession is the sum of the individual probabilities for all possible values of (m) is given by:

$$\sum_{m=0}^{m=m} (^{M}P_{m})^{n} = \sum_{m=0}^{m=m} (M^{m}.e{-}^{M}/m!)^{n}$$

By way of example, the probability of measuring 5 equal count in succession from an RPG with a Mean output of 1.683 pulses per measurement interval is as follows:

$$\sum_{m=0}^{m=m} (^{1.683}P_{m})^{5} = (e^{-1.683})^{5} . \sum_{m=0}^{m=m} (1.683^{m}.e{-}^{M}/m!)^{5}$$

$$= e^{-8.415} . [1+(1.683/1!)^{5} +(1+(1.683^{2}/2!)^{5}+(1+(1.683^{3}/3!)^{5}+...]$$

$$= 2.215 \times 10^{-4}. [1+13.50+5.697+0.317+0.004+...]$$

$$= 4.545 \times 10^{-3} = \underline{1/220}$$

In this way a 'win event is generated only when a plurality of successive or simultaneous counts all meet predetermined parameters. The cumulative probabilities of each count meeting its respective predetermined parameter are thus combined to achieve the overall desired 'win' probability.

Although the above equation may be used to determine the number of output pulses from the RPG and the number of successive measurements of the RPG output which are required to achieve a selected probability, as can be seen this is only possible with knowledge of the Mean output of the RPG. However, by employing the plural count analysis described above with the random event generator described herein, the need for knowledge of the Mean output of the RPG may be avoided.

As can be seen from the table above and Figure 1, the probabilities are high when an infinite numerical series is employed, where the separation is small between the integers. Therefore, in order for the random event generator to achieve the much lower probabilities associated with gaming machines, the above described method of employing the plural count analysis to generate a 'win' is employed.

For example, the analyser in the random event generator may be programmed so that an output is generated only when alternative successive counts from the RPG are divisible by 2 and 3. Thus,

1$^{st}$ count divisible by 2?     Probability =1/2
2$^{nd}$ count divisible by 3?     Probability = 1/2x1/3=1/6
3$^{rd}$ count divisible by 2?     Probability = 1/6x1/2=1/12
4$^{th}$ count divisible by 3?     Probability = 1/12x1/3=1/36
5$^{th}$ count divisible by 2?     Probability = 1/36x1/2=1/72
6$^{th}$ count divisible by 3?     Probability = 1/72x1/3=1/216

It will be appreciated that in this example to generate an output, or 'win', from the random event generator the successive counts are not equal (although they are clearly defined and sequential).

As a further example, to achieve a probability of 1/216 the analyser may be programmed so that it generates an output, or 'win', when six successive or simultaneous counts are made and the first three counts are divisible by two whilst the last three counts are divisible by three, or vice versa. Hence, the probability is: 1/2x1/2x1/2x1/3x1/3x1/3=1/216.

In order to determine the mathematical parameters necessary to achieve a desired probability, the value of the probability is reduced to its numerical factors and the factors determine the individual analyses to be performed on each of a plurality of counts. It will be apparent therefore that low probabilities which are prime numbers are not susceptible to this method.

Reference has been made to the use of the random event generator in a Pachinko machine. It is to be understood that the random event generator may be used in alternative gaming machines and under other circumstances where a random trigger is needed according to a precise probability, for example in message encryption and statistical quality control.

With the random event generator described above an output, or 'win, is generated according to a selected probability without any knowledge of the Mean output per measurement of the RPG in the random event generator. All that is necessary is that the counts per measurement equal or exceed 4 counts. As it is not necessary to accurately know the Mean of the RPG, this in turn means that only a loose specification of the output geometry of the RPG is required. Furthermore, shorter lived nuclides can be used because the radioactive decay and PIN diode degradation does not alter the 'win' probability. The use of shorter lived nuclides is preferred for environmental reasons as the need for long term waste disposal provisions is reduced. The use of shorter lived nuclides additionally reduces the risk of the random event generators being corrupted or re-programmed because the radioactive material decay more quickly to below the minimum threshold. These advantages similarly apply to the use of the random event generator in the generation of random numbers.

It will be appreciated that a wide variety of radioactive material may be employed in the random event generator. In particular, examples of the preferred shorter lived nuclides are: $^{210}$Po ($t_{1/2}$=138d), $^{252}$Cf($t_{1/2}$=2.64y), $^{208}$Po ($t_{1/2}$=2.9y) and $^{244}$Cm ($t_{1/2}$=18y).

The random event generator can be made very small, indeed small enough to be formed on a semiconductor chip, for example. Depending upon the radioactivity of the material used in the RPG shielding may or may not be necessary. One example of the type of applications where the random event generator would be useful when generating random numbers is with smart card technology.

**Claims**

1. A method of generating a random event comprising counting the number of pulses generated by a random pulse generator within a predetermined time period, determining whether the count of the number of pulses meets a selected mathematical parameter and generating an output when the count meets the selected mathematical parameter, the selected mathematical parameter requiring the count to equal an integer in a numerical series of equally spaced integers.

2. A method as claimed in claim 1, wherein it is determined whether the count meets the mathematical parameter by dividing the count by a selected integer and checking whether the result is also an integer.

3. A method as claimed in claim 1, wherein it is determined whether the count meets the mathematical parameter by summing the count with a selected first integer and then dividing the sum by a selected second integer and checking whether the result is also an integer.

4. A method as claimed in any one of the preceding claims, wherein the step of counting the number of pulses generated within a predetermined time period is repeated one or more times to generate a plurality of counts and wherein each of the plurality of counts is separately analysed to determine whether the count meets one or more selected mathematical parameters whereby an output is generated only when all of the plurality of counts meets the selected mathematical parameters.

5. A method as claimed in claim 4, wherein at least two mathematical parameters are used in the analysis of the plurality of counts divided into a corresponding number of groups of counts, a first group of the plurality of counts being analysed using a first mathematical parameter and at least one further group of the plurality of counts being analysed using at least one further mathematical parameter.

6. A method as claimed in any one of claims 1 to 3, wherein a plurality of counts are generated successively or simultaneously, each of the plurality of counts being separately analysed to determine whether each one of the counts meets at least one selected mathematical parameter and a corresponding output is generated for each of the counts in dependence on which of the mathematical parameters is met, whereby the plurality of outputs forms a numeric string.

7. A programmable probability random event generator comprising a random pulse generator and an analyser connected to the output of the random pulse generator; the analyser including means for counting the number of pulses generated by the random pulse generator during a predetermined time period, parameter means for determining whether the count of the number of pulses meets a selected mathematical parameter and output means for generating an output when the selected mathematical parameter is met; the selected mathematical parameter requiring the count to equal an integer in a numerical series of equally spaced integers.

8. A random event generator as claimed in claim 7, wherein the analyser includes memory means for storing one or more mathematical parameters.

9. A random event analyser as claimed in claim 8, wherein the analyser further includes selecting means for selecting one or more stored mathematical parameters in dependence on a desired probability.

10. A random event generator as claimed in claim 9, wherein there is further included factoring means for calculating the integer factors of a desired probability value and said selecting means is connected to the factoring means and selects one or more mathematical parameters in dependence on the calculated integer factors.

11. A random event generator as claimed in any one of claims 7 to 10, wherein the output of the analyser is connected to memory means for storing a plurality of outputs from the analyser in the form of a numeric string.

**European Patent Office**

**EUROPEAN SEARCH REPORT**

## DOCUMENTS CONSIDERED TO BE RELEVANT

| Category | Citation of document with indication. where appropriate. of relevant passages | Relevant to claim | CLASSIFICATION OF THE APPLICATION (Int.Cl.6) |
|---|---|---|---|
| X | R. HAYWARD ET AL.: ""ERNIE"-th Electronic Random Number INdicating Equipment for the Premium Savings Bonds Prize Draws" POST OFFICE ELECTRICAL ENGINEERS JOURNAL., vol. 50, April 1957, LONDON GB, pages 1-6, XP002042942 * page 2, right-hand column * | 1-7,11 | H03K3/84 |
| X | J. HAVEL: "The GENAP II Random Process Generator" ELECTRONIC ENGINEERING., vol. 40, no. 483, May 1968, LONDON GB, pages 7-11, XP002042943 * page 7-9 * | 1-7,11 | |
| X | VINCENT C H: "The generation of truly random binary numbers" JOURNAL OF PHYSICS E (SCIENTIFIC INSTRUMENTS), AUG. 1970, UK, vol. 3, no. 8, ISSN 0022-3735, pages 594-598, XP002042944 * page 594 * | 1-3,6,7, 11 | |

TECHNICAL FIELDS SEARCHED (Int.Cl.6)

H03K
G07C

The present search report has been drawn up for all claims

| Place of search | Date of completion of the search | Examiner |
|---|---|---|
| THE HAGUE | 8 October 1997 | Verhoof, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)